# EUROPEAN PATENT SPECIFICATION

(11) **EP 0 450 283 B1**
(45) Date of publication and mention of the grant of the patent: **18.09.1996**
(21) Application number: 91101770.5
(22) Date of filing: 08.02.1991
(51) Int. Cl.: H01L 27/12

(54) **SOI layout for low resistance gate**
SOI-Layout für ein Gate mit niedrigem Widerstand
Agencement silicium-sur-isolant pour une électrode de porte à faible résistance

(30) Priority: 02.03.1990 US 488331
(43) Date of publication of application: 09.10.1991
(73) Proprietor: TEXAS INSTRUMENTS INCORPORATED, Dallas Texas 75265 (US)
(72) Inventor: Houston, Theodore W., Richardson, Texas 75080 (US); Blake, Terence G. W., Dallas, Texas 75243 (US)
(74) Representative: Leiser, Gottfried, Dipl.-Ing.

(56) References cited:
- EP-A- 0 128 581
- US-A- 4 864 380

## Description

### BACKGROUND OF THE INVENTION

The invention relates to a transistor structure comprising a commonly gated first transistor and a second transistor, said transistors being formed in a thin film of semiconductor material overlying an insulator, each transistor having a pair of source/drain region and a body region formed therebetween, said thin film being patterned to form a mesa for each transistor and a mesa extension of semiconductor material extending in a first direction from. the body region of said first transistor to the body region of said second transistor so as to form a substantially planar surface of mesa.

A transistor structure of this type is shown in US-A-4,864,380. In this structure the mesa extension has the same width as the mesas and completely fills the spaces between the mesas. No portion of the mesa extension is provided having side edges aligned with side edges of the common gate.

Conventional forming of a transistor in a mesa isolated silicon-on-insulator (SOI) structure has involved a mesa edge at the edge of the transistor and has required the gate material to cover the step at the mesa edge. This results in step coverage problems in the gate material and can also increase the gate resistance. Additionally, transistor leakage can occur at the edge of the transistor.

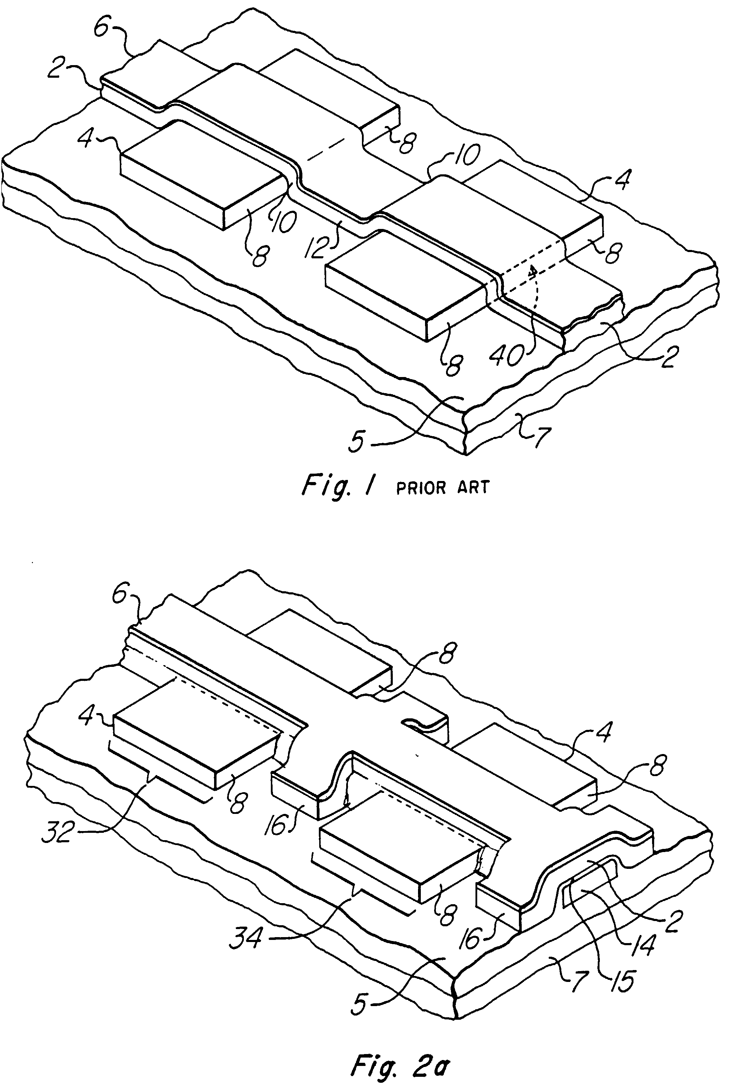

Figure 1 illustrates a three-dimensional view of a prior art mesa-isolated SOI structure which is susceptible to the afore mentioned problems. As shown, polycrystalline semiconductor material, such as, polycrystalline silicon (hereinafter referred to as poly) 2 is placed in a step-like fashion over each mesa 4 which is patterned out of single crystalline silicon or other semiconductor material. Silicide 6 is grown over poly 2 in order to reduce the surface resistance of a gate, for a field effect transistor formed of the silicided polycrystalline silicon. Alternatively, other metal could be placed over poly 2. The mesas overlie insulator 5 such as silicon dioxide which may overlie semiconductor material such as silicon 7. Each mesa includes a source/drain region 8 and a body region (view obscured by poly 2). The source/drain region of the mesa is capable of serving as either a transistor source or a transistor drain. The body region is capable of serving as the body of a transistor. Body is a term commonly used in the SOI art to refer to the substrate of a field effect transistor between the source and drain which lies underneath the gate. Silicide 6 may not uniformly cover poly 2 at a step region 10 where poly 2 is substantially vertical, thereby leading to increased gate resistance. The structure illustrated in Figure 1 is also susceptible to current leakage at the edge of each mesa 4 through the mechanism of a current path from region 8 on one mesa to region 8 on another mesa along a vertical edge 12 of poly 2.

### OBJECT OF THE INVENTION

It is an object of the invention to provide a new and improved transistor in a mesa isolated silicon-on-insulator structure.

It is another object of the invention to eliminate step coverage problems in a mesa isolated silicon-on-insulator structure.

These and other objects of the invention, together with the features and advantages thereof, will become apparent from the following detailed specification when read together with the accompanying drawings in which applicable reference numerals have been carried forward.

### SUMMARY OF THE INVENTION

The foregoing objects of the invention are accomplished by providing said mesas with a width in a second direction, substantially orthogonal to said first direction greater than the width of the mesa extension underlying the common gate, at least a portion of said mesa extension having side edges aligned with side edges of the common gate, and by providing gate extension isolation tabs formed on said insulator adjacent opposing sides of said mesa extension, said tabs located between and spaced from said means.

### BRIEF DESCRIPTION OF THE DRAWINGS

Figure 1 illustrates a three dimensional view of a prior art mesa isolated SOI structure.
Figure 2a illustrates a three dimensional view of the preferred embodiment of the invention.
Figure 2b illustrates a top view of an alternative embodiment of the invention.
Figure 2c illustrates a top view of another alternative embodiment of the invention
Figure 3 illustrates a cross-sectional view of the semiconductor extension between mesas in the preferred embodiment of the invention.
Figure 4 illustrates a cross-sectional view of isolation tabs in the preferred embodiment of the invention.
Figure 5 illustrates a top view of the preferred embodiment of the invention.

### DETAILED DESCRIPTION OF THE INVENTION

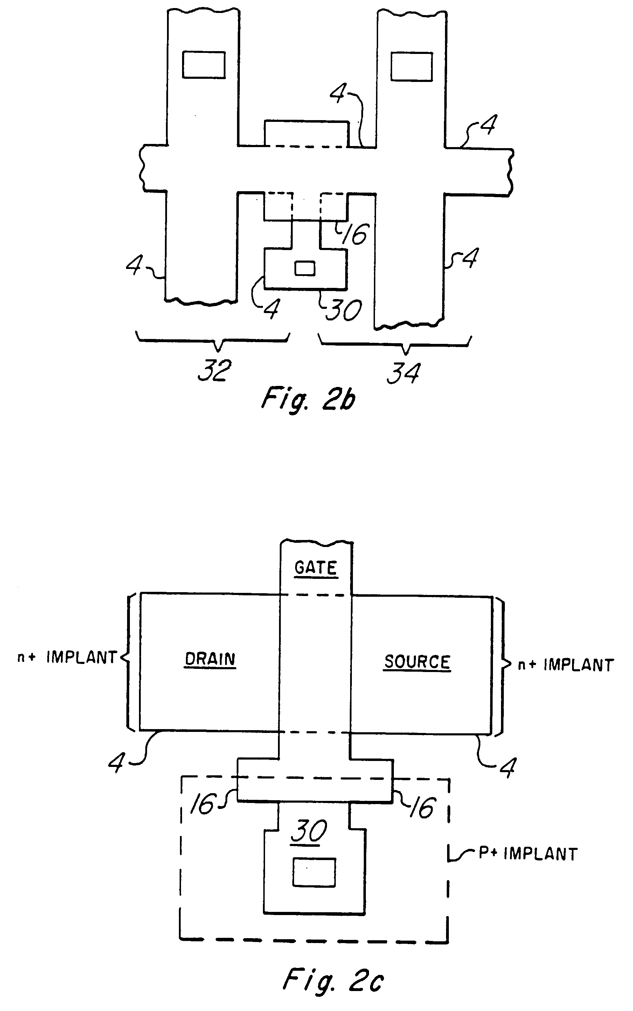

Figure 2a is a drawing illustrating a three dimensional view of the preferred embodiment of the invention. As shown, each mesa 4 is connected to the other by an extension of semiconductor material 14, such as silicon, which serves to provide a substantially planar surface between each mesa 4. Poly 2 is placed over the mesa. Note, that no step-like structure exists along the extent on which poly 2 is placed. Thus, silicide 6, or other metal, can be distributed over poly in such a manner which better encourages a continuous and a more even distribution of silicide 6 or other metal over poly 2. Elimination of edge leakage problems are also addressed by the structure illustrated in Figure 2a. A threshold voltage adjust is performed by implanting dopants into the semiconductor of the mesa between transistors so as to raise the threshold voltage of the parasitic transistor on that mesa connecting the transistors built on each mesa, thereby substantially shutting off the parasitic transistor thus reducing parasitic current. Additionally, an implant with a goal toward reducing carrier mobility can be performed so as to reduce parasitic current. For instance, an implant of neutrons will damage the crystalline lattice structure of the semiconductor sufficiently to reduce carrier mobility. Alternatively, germanium can be implanted. Poly (polycrystalline) gate extension isolation tabs 16 provide added isolation between transistors built on each mesa 4. The foregoing planar structure substantially eliminates current leakage along the edge of a mesa from source to drain as would be found in a structure without the mesa extension (for instance, along the edge indicated by arrow 40 in Figure 1.

The mesa extension between transistors can also serve as the body node of both transistors. This is a compact way to make contact to two pass transistors as, for example, in the access transistors of a static random access memory (RAM) cell. Figure 2b illustrates a top view of such an alternative embodiment of the invention. Body node contact 30 serves to provide a common contact area to the bodies of transistor regions 32 and 34.

The body contact structure can also be used with a single transistor as shown in the top view of an alternative embodiment of the invention in figure 2c. Poly isolational tabs 16 control the parasitic gate along the sidewall of mesa 4. Body node contact 30 is connected to the body node of the transistor by the mesa extension which lies under the transistor gate. Source and drain regions are shown in figure 2c. In constructing such a body node contact, a p+ (heavily doped p-type semiconductor) implant overlaps body node contact 30. However, this implant does not extend any further than tab 16 which shields the mesa extension from the implant. The rest of the structure (assuming n-channel transistors) is given a n+ implant). For a p-channel transistor structure just the opposite dopant-type implants are used.

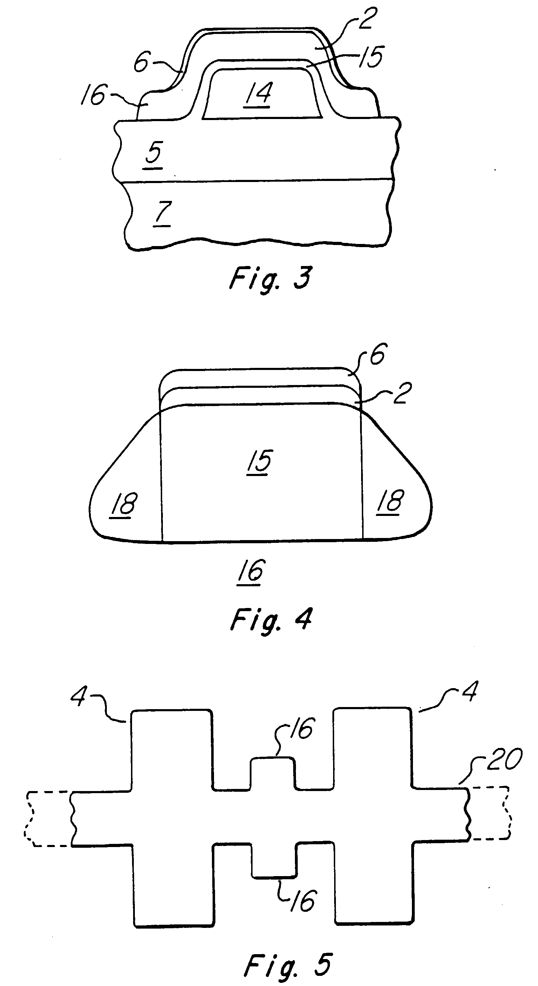

Figure 3 is a drawing which shows a cross-sectional view of semiconductor extension 14, between mesas.

Figure 4 illustrates a cross-sectional view of poly tabs 16. This structure can be built along with the rest of the mesa extension in formation of the silicided polycrystalline gate to yield the layered structure shown with single crystalline semiconductor, i.e., silicon 15, under layers of poly 2 and silicide 6, flanked by an insulator such as, sidewall oxide 18.

Figure 5 illustrates a top view of each mesa 4, the common gate 20 for the transistors formed in the mesas and tabs 16 in the preferred embodiment of the invention. As shown, it is evident that tabs 16 additionally serve to isolate transistors formed in mesas 4 even in the instance where common gate 20 is misaligned relative to mesas 4.

The foregoing discussed structures can be constructed according to well known SOI field effect transistor fabrication methods. Although the invention was discussed with reference to two transistors, it is to be understood that more transistors integrated into larger circuit schemes including a common gate are contemplated for use in conjunction with the invention. For instance, the common gate previously referenced can represent a word line in a random access memory which is either dynamic or static. The tabs previously discussed can be made of the same material as the gate.

Although the invention has been described in detail herein with reference to its preferred embodiment and certain described alternatives, it is to be understood that this description is by way of example only, and is not to be construed in a limiting sense.

## Claims

1. A transistor structure comprising: a commonly gated first transistor and second transistor, said transistors being formed in a thin film of semiconductor material overlying an insulator (5), each transistor having a pair of source/drain regions (8) and a body region formed therebetween, said thin film being patterned to form a mesa (4) for each transistor and a mesa extension (14) of semiconductor material extending in a first direction from the body region of said first transistor to the body region of said second transistor so as to form a substantially planer surface of mesa, said mesas (4) having a width in a second direction substantially orthogonal to said first direction greater than that of said mesa extension (14), said mesa extension (14) underlying the common gate (6, 20), at least a portion of said mesa extension (14) having side edges aligned with side edges of said common gate (6, 20), said transistor structure further comprising gate extension isolation tabs (16) formed on said insulator (5) adjacent opposing sides of said mesa extension (14), said tabs (16) located between and spaced from said mesas (4).

2. A transistor structure as recited in claim 1 wherein said isolation tabs (16) comprise semiconductor material flanked with a sidewall insulator.

3. A transistor structure as recited in claim 2 wherein said sidewall insulator is oxide.

4. A transistor structure as recited in claim 1 wherein parasitic current is reduced by implanting dopants into the mesa between said transistors so as to raise the threshold voltage of a parasitic transistor formed between said first and second transistors.

5. A transistor structure as recited in claim 1 wherein a body node contact (30) is made to the mesa extension (14) between said two transistors.

## Patentansprüche

1. Transistorstruktur, enthaltend: erste und zweite Transistoren mit gemeinsamem Gate, wobei die Transistoren in einer dünnen Schicht aus Halbleitermaterial über einem Isolator (5) gebildet sind und jeder Transistor zwei Source/Drain-Zonen (8) und einen dazwischen gebildeten Körperbereich aufweist, wobei die dünne Schicht so strukturiert ist, daß für jeden Transistor (4) ein Mesa und eine Mesaverlängerung (14) aus Halbleitermaterial gebildet werden, die sich in einer ersten Richtung von dem Körperbereich des ersten Transistors aus zu dem Körperbereich des zweiten Transistors erstreckt, so daß eine wesentlich ebenere Mesafläche entsteht, wobei die Mesas (4) in einer zweiten Richtung, die im wesentlichen senkrecht zu der ersten Richtung verläuft, eine Breite haben, die größer als die der Mesaverlängerung (14) ist, wobei die Mesaverlängerung (14) unter dem gemeinsamen Gate (6, 20) liegt, wobei wenigstens ein Abschnitt der Mesaverlängerung (14) Seitenränder aufweist, die in einer Richtung mit den Seitenrändern des gemeinsamen Gates (6, 20) verlaufen, wobei die Transistorstruktur ferner Gateverlängerungs-Isolierstreifen (16) aufweist, die auf dem Isolator (5) angrenzend an gegenüberliegende Seiten der Mesaverlängerung (14) gebildet sind und zwischen den Mesas (4) im Abstand von diesen liegen.

2. Transistorstruktur nach Anspruch 1, bei welcher die Isolierstreifen (16) aus Halbleitermaterial bestehen, an dessen Seitenflanken sich ein Seitenwandisolator befindet.

3. Transistorstruktur nach Anspruch 2, dadurch gekennzeichnet, daß der Seitenwandisolator ein Oxid ist.

4. Transistorstruktur nach Anspruch 1, bei welcher ein parasitärer Strom reduziert wird, indem in den Mesa zwischen den Transistoren Störstoffe implantiert werden, so daß die Schwellenspannung eines zwischen den ersten und zweiten Transistoren gebildeten parasitären Transistors reduziert wird.

5. Transistorstruktur nach Anspruch 1, bei welcher ein Körperanschlußkontakt (3) zu der Mesaverlängerung (14) zwischen den zwei Transistoren gebildet ist.

## Revendications

1. Structure à transistors comprenant : un premier transistor et un second transistor à grille commune, lesdits transistors étant formés en un film mince d'un matériau semiconducteur recouvrant un isolant (5), chaque transistor possédant un couple de régions de source/drain (8) et une région formant corps située entre ces régions, ledit film mince étant structuré de manière à former une structure mesa (4) pour chaque transistor, et un prolongement mesa (14) du matériau semiconducteur s'étendant dans une première direction à partir de la région formant corps dudit premier transistor en direction de la région formant corps dudit second transistor de manière à former une surface nettement plus plane de la structure mesa, lesdites structures mesa (4) possédant une largeur dans une seconde direction, sensiblement perpendiculaire à ladite première direction, qui est supérieure à celle dudit prolongement mesa (14), ledit prolongement mesa (14) étant situé au-dessous de la grille commune (6,20), au moins une partie dudit prolongement mesa (14) possédant des bords latéraux alignés avec des bords latéraux de ladite grille commune (6,20), ladite structure à transistors comprenant en outre des pattes isolantes d'extension de grille (16) formées sur ledit isolant (5) au voisinage de côtés opposés dudit prolongement mesa (14), ledites pattes (16) étant situées entre et espacées par rapport auxdites structures mesa (4).

2. Structure à transistors selon la revendication 1, dans laquelle lesdites pattes isolantes (16) comprennent un matériau semiconducteur flanqué d'un isolant de paroi latérale.

3. Structure à transistors selon la revendication 2, dans laquelle ledit isolante de paroi latérale est un oxyde.

4. Structure à transistors selon la revendication 1, dans laquelle le courant parasite est réduit par implantation de substances dopantes dans la structure mesa entre lesdits transistors de manière à accroître la tension de seuil d'un transistor parasite formé entre lesdits premier et second transistors.

5. Structure à transistors selon la revendication 1, dans laquelle le contact (30) en noeud de la région formant corps est formé jusqu'au prolongement mesa (14) entre lesdits deux transistors.
